# EUROPÄISCHE PATENTSCHRIFT

(11) **EP 2 006 883 B1**
(45) Veröffentlichungstag und Bekanntmachung des Hinweises auf die Patenterteilung: **18.12.2013**
(21) Anmeldenummer: 08104050.3
(22) Anmeldetag: 21.05.2008
(51) Int. Cl.: H01L 21/67

(54) **Vorrichtung zur Dotierung, Beschichtung oder Oxidation von Halbleitermaterial bei niedrigem Druck**
Device for doping, coating or oxidizing a semiconductor material under a low pressure
Dispositif de dopage, revêtement ou oxidation pour un matériau semiconducteur sous une basse pression

(30) Priorität: 21.05.2007 DE 102007023812; 28.12.2007 DE 102007063363
(43) Veröffentlichungstag der Anmeldung: 24.12.2008
(73) Patentinhaber: Centrotherm Photovoltaics AG, 89143 Blaubeuren (DE)
(72) Erfinder: Piechulla, Alexander, 89143 Blaubeuren (DE); Rade, Claus, 89604 Allmendingen (DE); Hartung, Robert Michael, 89143 Blaubeuren (DE)
(74) Vertreter: Heyerhoff Geiger & Partner Patentanwälte

(56) Entgegenhaltungen:
- JP-A- 2005 285 941
- US-A- 4 348 580
- US-A- 4 640 223
- US-A1- 2007 080 156

## Beschreibung

Die Erfindung betrifft eine Vorrichtung zur Dotierung, Beschichtung oder Oxidation von Halbleitermaterial bei niedrigem Druck in einem Prozessrohr, das mit einem Rohrverschluss sowie Einrichtungen zur Zu- und Ableitung von Prozessgasen und zur Erzeugung eines Unterdruckes im Prozessrohr versehen ist.

Im Vergleich zur Diffusion bei Atmosphärendruck ermöglicht die Diffusion bei niedrigem Druck bekanntermaßen die Verringerung des Abstandes der Wafer zueinander und damit die Beladung des Prozessrohres mit einer höheren Anzahl von Siliziumscheiben unter Beibehaltung oder Verbesserung der Homogenität der Dotierung. Voraussetzung ist, dass das Prozessrohr oder der Ofen so evakuierbar und vakuumdicht sein muss, dass ein ausreichend niedriger Prozessdruck erreicht wird. Als ausreichend niedriger Prozessdruck kann beispielsweise ein Prozessdruck um 200 mbar angesehen werden.

Weiterhin dürfen die Ausgangs- und Reaktionsprodukte nicht mit Materialien in Kontakt kommen, die dadurch angegriffen würden und es dürfen sich diese Produkte nicht in dem Reaktionsrohr/Ofen ansammeln.

Bei den bisher bekannt gewordenen Vorrichtungen (z.B. EP 1 393 351 A1) zur Phosphordotierung bei niedrigem Druck mit Phosphorychlorid als Dotierstoff treten erhebliche Probleme auf. So entsteht eine Kondensation von Phosphoroxid an Oberflächen und zwar insbesondere im Bereich des Rohrverschlusses sowie an dem Ende des Prozessrohres, an dem eine Pumpe angeschlossen ist und auch an der Abgasstrecke zwischen Prozessrohr und Pumpe sowie in der Pumpe selbst. Der Grund liegt darin, dass die Temperatur in diesen Bereichen deutlich niedriger ist, als die Prozesstemperatur.

Durch den Kontakt mit Wasser, insbesondere von Luftfeuchtigkeit nach dem Belüften der Vorrichtung mit reinem Stickstoff und reinem Sauerstoff beim Öffnen des Rohrverschlusses, wandelt sich das Phosphoroxid in Phosphorsäure um. Die fatalen Folgen sind Korrosion von Bestandteilen der Vorrichtung aus Metall, wie z.B. der Rohrverschluss und die nachfolgende Verunreinigung des Prozessrohres mit den Korrosionsprodukten und die Verunreinigung der Produkte, die in der Vorrichtung bearbeitet werden, beispielsweise durch Eisenkontamination von Silizium.

Weiterhin besteht die Gefahr, dass Phosphorsäure aus dem Prozessrohr austritt, oder dass sich Reaktionsprodukte im Prozessrohr und den damit verbundenen Komponenten der Vorrichtung ansammeln. Die mit dem Prozessrohr verbundenen Komponenten können Verkleben und es besteht die Gefahr der Zersetzung des Prozessrohres und der damit verbundenen Komponenten. Schließlich können die Ansammlungen eine unerwünschte Dotierwirkung entfalten.

Auch können die Reaktionsprodukte wie Chlor, Salzsäure, Phosphoroxid und Phosphorsäure eine Korrosion, einschließlich Quarzkorrosion, verursachen.

Bei einer Vorrichtung in "Cantilever"-Bauart bleibt das Paddle während des Prozesses im Prozessrohr, wird dabei auf die Prozesstemperatur erwärmt und wird mit hoher Temperatur nach Prozessende wieder ausgefahren. Bei der "Cantilever"-Bauart ist z.B. am hinteren Ende des Paddles ein Zylinder aufgesetzt, dessen Oberfläche von einem Dichtring umfasst wird. Es wird ebenso auf den folgenden Stand der Technik Bezug genommen: US 4640223; US 4348580, JP200528594 und US-A1-20070080156.

Der Erfindung gemäß dem Anspruch 1 liegt die Aufgabe zugrunde, eine Vorrichtung zur Dotierung, Beschichtung und Oxidation von Halbleitermaterial bei niedrigem Druck in einem Prozessrohr zu schaffen, bei der die eingangs genannten Nachteile vermieden werden.

Es handelt sich damit um einen zweistufigen Verschluss des Prozessrohres, bestehend aus einem gasdichten Hochtemperaturverschluss mit geringer Leckrate und einem vakuumdichten Verschluss.

Der Kragen überragt das Prozessrohr stirnseitig, so dass innerhalb des Kragens ein Kragenraum entsteht, der durch die Tür nach außen vakuumdicht verschließbar ist.

Die vakuumdichte Abdichtung des Rohrverschlusses mit der Tür erfolgt unter Zwischenlage einer Dichtung, die stirnseitig an den Kragen anlegbar ist.

Der Stopfen besteht bevorzugt aus Quarz, SiC oder einem anderen geeigneten hinreichend temperaturfesten und medienresistenten Material, oder ist mit einem solchen Material beschichtet und ist an der Innenseite der Tür lösbar und federbelastet befestigt, so dass ein leichter Austausch desselben möglich ist.

Die Befestigung des Stopfens an der Tür erfolgt idealerweise mittels eines Bajonettverschlusses.

Um eine möglichst leichte Türkonstruktion zu erreichen, ist die Tür aus Aluminium, oder einem anderen Leichtmetall gefertigt.

Ein besonderer Vorteil der erfindungsgemäßen zweistufigen Dichtung ist darin zu sehen, dass die Tür wassergekühlt ausgeführt werden kann, ohne dass dadurch eine Beeinflussung der Prozesstemperatur im Prozessraum damit verbunden wäre. Außerdem lässt sich dadurch eine Türabdichtung mit thermoplastischen oder elastischen Materialien realisieren.

Die Tür ist zu diesem Zweck mit einem Kühlwassereinlass und einem Kühlwasserauslass zur Hindurchleitung eines Kühlmittels versehen, wobei die Verteilung des Kühlmittels durch eine ringförmige Nut in der Tür erfolgt.

Um den Kragenraum mit Spülgas füllen zu können, ist die Tür mit einem Spülgaseinlass zur Einleitung eines Spülgases in den Kragenraum versehen und weist einen Spülgasauslass/Abpumpanschluss auf. Der Spülgasauslass/Abpumpanschluss kann mit einer separaten Pumpe verbunden sein.

Eine einfachere Konstruktion ist dadurch gekennzeichnet, dass der Spülgasauslass über eine Schlauchleitung mit einem Gasführungsrohr und einer Pumpe zum Abpumpen des Spülgases aus der Kammer und gleichzeitig der Prozessgase aus dem Prozessraum verbunden ist.

Der Spülgaseinlass mit einer Quelle für Stickstoff oder einem anderen geeigneten Gas verbunden.

Um zu verhindern, dass Prozessgasanteile in den Kragenraum entweichen können, besteht im Kragenraum ein Überdruck gegenüber dem Prozessraum im Prozessrohr.

Die Druckdifferenz beträgt zwischen Null und ca. 50 mbar.

Für die Evakuierung des Prozessraumes und des Kragenraumes und zur gleichzeitigen Erzeugung der Druckdifferenz zwischen Prozessraum und Kragenraum ist zweckmäßigerweise eine gemeinsame Pumpe vorgesehen.

In einer weiteren Ausgestaltung der Erfindung ist zur Erzeugung der Druckdifferenz die Verbindung des Kragenraumes zur Pumpe mit einer im Vergleich zur Prozessrohrabsaugung langen Leitung mit geringerem Querschnitt ausgeführt.

Um die Belastung der Pumpe zu reduzieren, ist vor dieser eine Kühlfalle angeordnet, in der die abgesaugten Prozess- und Spülgase gekühlt werden.

Die Pumpe kann als Membranpumpe, Schraubenpumpe oder Strahlpumpe, d.h. als Flüssigkeitsstrahlpumpe ausgebildet sein.

Weiterhin ist zur Ausbildung der Druckdifferenz eine passende Leckrate der Berührungsstelle von Quarzstopfen und dem Dichtungsrand des Prozessrohres durch einen Planschliff der sich berührenden Flächen eingestellt.

In einer weiteren Ausgestaltung der Erfindung ist der Prozessgasauslass zur Ableitung der Prozessgase an der dem Rohrverschluss gegenüber liegenden Ende des Prozessrohres angeordnet.

Der Prozessgasauslass ist bevorzugt mit einem Kugelschliff versehen, um einerseits eine ausreichende Dichtheit zu gewährleisten und andererseits eine gewisse Undichtigkeit zuzulassen, so dass durch angesaugte Umgebungsluft eine Spülung der Verbindungsstelle zu gewährleisten. Damit wird sicher verhindert, dass sich eventuell Prozessgasrückstände absetzen können.

Der Prozessgasauslass kann entweder nach unten geneigt, oder horizontal ausgerichtet sein.

Bevorzugt ist der Prozessgasauslass um ca. 5° nach unten geneigt.

Weiterhin ist der Kugelschliff am Gasauslass zum Anschluss und zur Hindurchführung einer Gasauslasslanze ausgebildet.

Die Absaugung des Kragenraumes erfolgt durch das Gasführungsrohr über ein T-Stück, durch welches das Gasführungsrohr geführt ist.

Für den Prozessgaseinlass in den Prozessraum ist ein Koaxialrohr als Bestandteil einer Gaseinlasslanze auf der Seite des Prozessgasauslasses vorgesehen, die bis an den Quarzstopfen auf der anderen Seite des Prozessrohres reicht, ohne diesen zu berühren.

Die Erfindung soll nachfolgend an einem Ausführungsbeispiel näher erläutert werden. In den zugehörigen Zeichnungen zeigen:
- Fig. 1:: eine schematische Darstellung eines erfindungsgemäßen Prozessrohres mit Absaugung und Gaseinlass (zeichnungsgemäß links);
- Fig. 2:: eine perspektivische Darstellung einer Tür zum Verschluss des Prozessrohres nach Fig. 1;
- Fig. 3:: eine Seitenansicht des Tores mit Quarzstopfen;
- Fig. 4:: Einzelheiten eines Bajonettverschlusses auf der Innenseite des Quarzstopfens;
- Fig. 5:: ein koaxiales Gaseinlassrohr für den Gaseinlass in das Prozessrohr nach Fig. 1;
- Fig. 6:: Einzelheiten einer Gasauslasslanze für die Absaugung des Prozessrohres nach Fig. 1;
- Fig. 7:: eine schematische Übersichtsdarstellung der erfindungsgemäßen Vorrichtung.

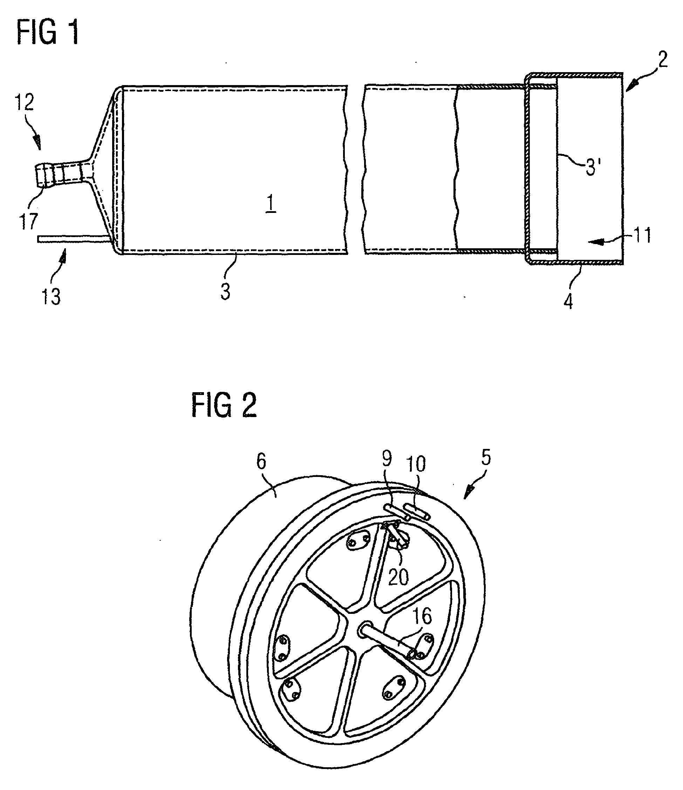

Kern der Erfindung ist, dass der Abschluss des Prozessraumes 1 gegen die umgebende Atmosphäre und die Abdichtung des Rohrverschlussendes 2 räumlich voneinander getrennt in einer loaxialen oder hintereinander liegenden Anordnung ausgeführt sind. Das aus Quarz bestehende Prozessrohr 3 besitzt am Rohrverschlussende 2 einen Kragen 4, d.h. ein koaxiales Rohrstück, das an das innere Rohr, also an das Prozessrohr 3, angeglast ist und dieses ein Stück weit überragt (Fig. 1). Der Kragen 4 am Prozessrohr 3 angeglast oder anderweitig befestigt sein und kann zusätzlich von Isoliermaterial umgeben sein (nicht dargestellt). Der Rohrverschluss selbst ist zweistufig ausgeführt und besteht aus einer Tür 5 aus Metall zur Sicherung der Vakuumdichtheit, an der ein "versenkter" Stopfen aus Quarz (Quarzstopfen 6) angebracht ist (Fig. 2 - 4). Der Rand des Bodens des Quarzstopfens 6 liegt im geschlossenen Zustand der Tür 5 am Dichtungsrand 3' das Prozessrohres 3 federbelastet an. Der Stopfen besteht aus Quarz, SiC bzw. einem anderen hinreichend temperaturfesten und medienresistenten Material. Der Stopfen kann auch mit einem dieser Materialien oder zusätzlich beschichtet sein.

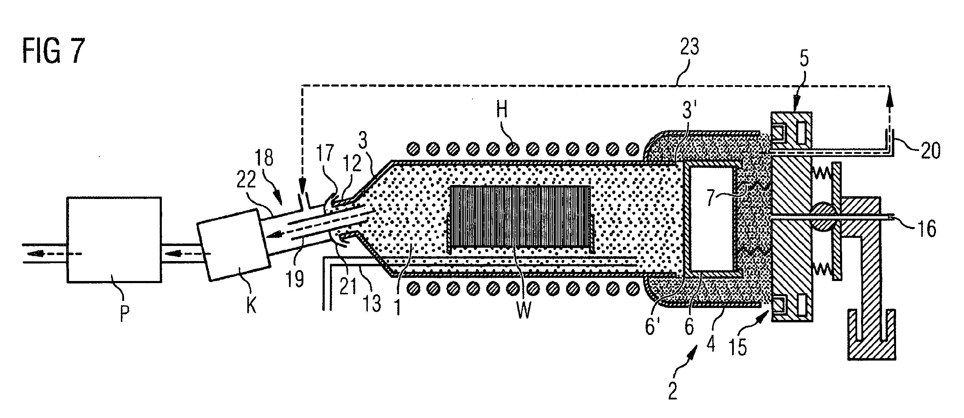

Das Rohrverschlussende 2 dient im geöffneten Zustand, d.h. bei geöffneter Tür 5, zum Ein- und Ausfahren des in einem Boot nebeneinander oder übereinander aufgestellten Halbleitermaterials in Form von Wafern W o.dgl., die im Prozessraum 1 zu behandeln sind (Fig. 7).

Der Quarzstopfen 6 ist in seinem Inneren mit einem Isoliermaterial, wie Formteilen aus Keramikfaser, Platten und lose Wolle auf der Basis von Aluminiumsilikatfasern, gefüllt und kann einen opaken Boden besitzen. Die Füllung mit dem Isoliermaterial dient der Erzeugung eines Temperaturgradienten in Richtung zur Tür 5, derart, dass die Temperatur vom Boden des Quarzstopfens 6 in Richtung zur Tür 5 abnimmt.

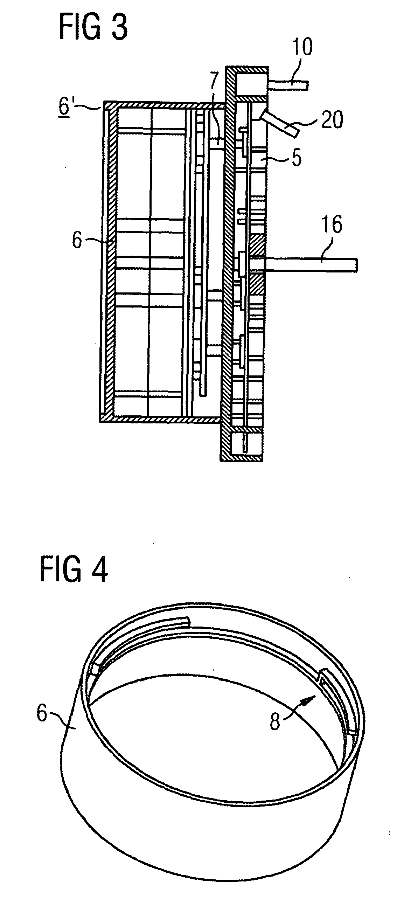

Der Quarzstopfen 6 ist mit mehreren Federelementen 7 an der Tür 5 des Rohrverschlusses befestigt (Fig. 3, 7). Die Federelemente 7 können aus Edelstahl oder einem anderen ausreichend Temperatur beständigen Material bestehen.

Die Federkraft der Federelemente 7, d.h. die Kraft, mit welcher der Boden des Quarzstopfens 6 an den Dichtungsrand 3' des Prozessrohres 3 anlegbar ist, kann von außen über Schrauben oder andere Stellmittel eingestellt werden, die während des Betriebes des Prozessrohres 3 vakuumdicht verdeckt sind. Als Federelemente werden z.B. Edelstahlfedern eingesetzt.

Im Innern des Zylinders des Quarzstopfens 6 befindet sich an der zur Tür 5 gewandten Seite ein Bajonettverschluss 8 (Fig. 4). Das entsprechende Gegenstück an der Tür 5 besteht aus Edelstahl. Die Sicherung und Einspannung des Bajonettverschlusses 8 erfolgt mit Hilfe einer nicht dargestellten Quarzschnur. Damit kann der Quarzstopfen 6 im Bedarfsfall schnell ausgetauscht werden.

Die Außentür 5 des Rohrverschlusses besteht aus Aluminium und ist wassergekühlt. Dazu befinden sich in Inneren Bohrungen und Kanäle, die von der Kühlflüssigkeit durchströmt werden. Weiterhin befindet sich an der Tür 5 ein Kühlwassereinlass 9 und ein Kühlwasserauslass 10, wobei das Kühlwasser über eine ringförmige Nut in der Tür 5 verteilt wird (Fig. 2, 3). Zusätzlich kann an der Tür 5 ein Drucksensor angebracht sein, mit dem der Druck im Kragenraum 11 gemessen werden kann.

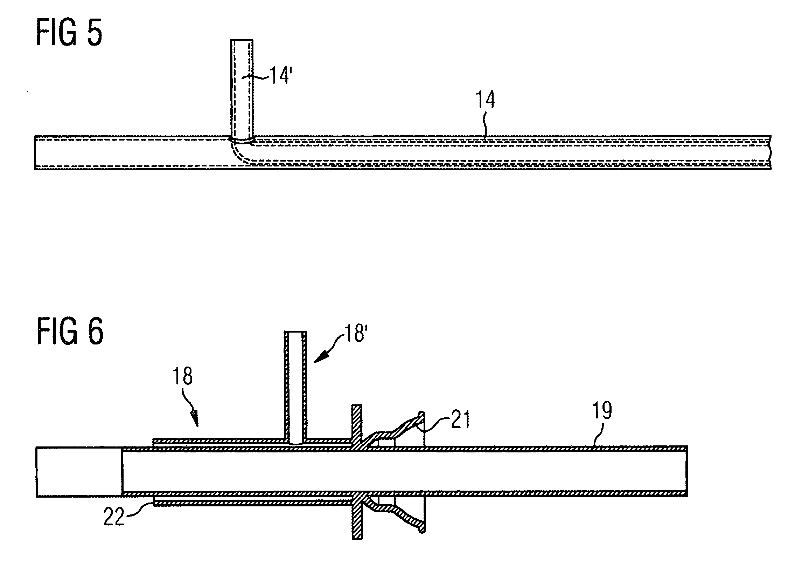

Das Prozessrohr 3 ist von einer Heizeinrichtung H (Fig. 7) und einer Isolation umgeben (nicht dargestellt). Weiterhin ist das Prozessrohr 3 am zeichnungsgemäß linken Ende mit einem zentralen Prozessgasauslass 12 in Form eines Ansaugstutzens zum Abpumpen der Prozessgase versehen (Fig. 1, 6). Darunter befinden sich mehrere Stutzen 13, in die eine Quarzlanze mit einem Thermoelement sowie die nötigen Gaseinlasslanzen (Koaxialrohr 14, Fig. 5) eingeschoben werden können. Die Gaseinlasslanzen können so lang ausgeführt sein, dass sie fast bis zum Boden des Quarzstopfens 6 auf der zeichnungsgemäß rechten Seite des Prozessrohres 3 reichen (Fig. 7). Für den Gaseinlass kann auch ein Koaxialrohr 14 eingesetzt werden, in das wahlweise Prozessgase durch das innere Rohr 14' und das äußere Rohr 14 geführt werden können (Fig. 6).

Das Prozessgas wird unten über einen Stutzen 13 eingelassen und zum gegenüber liegenden Ende des Prozessrohres 3 geführt. Von dort strömt es zum anderen Ende des Prozessrohres 3 und wird dort über einen zentralen Rüssel, den Prozessgasauslass 12, abgesaugt.

Zum vakuumdichten Verschließen des Prozessrohres 3 wird die Tür 5 mit einer Dichtung 15 gegen den Stirnrand des Kragens 4 gedrückt. Innen drückt der geschliffene Rand 6' des Quarzstopfens 5 federbelastet dichtend gegen den Dichtungsrand 3' des Prozessrohres 3, so dass der Prozessraum 1 vollständig von Quarz umgeben ist und gleichzeitig vakuumdicht verschlossen ist (Fig. 3, 7).

Zur Spülung und Evakuierung des Rohrverschlusses, z.B. mit Stickstoff, ist die Tür 5 mit einem Spülgaseinlass 16 und einem Spülgasauslass 20 versehen. Der Spülgasauslass 20 dient gleichzeitig als Abpumpanschluss (Fig. 3) mit dem der Bereich Kragen-Quarzstopfen-Tür, d.h. der Kragenraum 11, evakuiert werden kann.

Der Spülgasein- und -auslass 16, 20 dient nach dem Beladen des Prozessrohres 3 und dem Schließen der Tür 5 zum Ausspülen von Luft und während der Niederdruckbelegung zum Ausspülen von in den Kragenraum 11 ausdiffundierten Reaktionsprodukten.

Der Kragenraum 11 wird während des Prozesses mit Stickstoff gespült, damit sich ein Überdruck gegenüber dem Prozessraum 1 im Prozessrohr 3 ausbildet. Auf diese Weise wird verhindert, dass die Ausgangs- und Reaktionsprodukte aus dem Prozessraum 1 bis an die aus Metall bestehende Tür 5 gelangen können (Fig. 2, 7).

Zwischen dem Prozessraum 1 und dem Kragenraum 11 sollte eine Druckdifferenz von z.B. 50 mbar herrschen. Allerdings darf der Druckunterschied nicht zu groß sein, da sonst der Boden des Quarzstopfens 6 zerbrechen kann. Eine höhere Festigkeit kann hier ein in Richtung zum Prozessraum 1 gewölbter Boden des Quarzstopfens 6 bieten.

Der Überdruck im Kragenraum 11 unterstützt das Andrücken des Quarzstopfens 6 an das Prozessrohr 3. Die nicht zu vermeidende Leckage zwischen Quarzstopfen 6 und Prozessrohr 3, d.h. zwischen dem geschliffenen Dichtrand 3' und dem geschliffenen Rand 6', kann zu einer hier erwünschten Spülwirkung an dieser Stelle führen.

Die Evakuierung des Prozessraumes 1 und des Kragenraumes 11 erfolgt mittels derselben Pumpe P unter Erzeugung einer Druckdifferenz zwischen Prozessraum 1 und Kragenraum 11. Als Pumpe P kommt hier eine Membranpumpe, bzw. eine Schraubenpumpe oder eine Strahlpumpe in Betracht. Vor der Pumpe P kann zu deren Schutz eine Kühlfalle K angeordnet werden, wodurch gleichzeitig eine Verringerung von Abgas und Flüssigkeit hinter der Pumpe P erreicht wird (Fig. 7).

Die Verbindung des Abpumpanschlusses 20 des Kragenraumes 11 zur Pumpe P ist zwecks Erzeugung der Druckdifferenz mit einer im Vergleich zur Prozessrohrabsaugung langen Leitung 23 mit geringem Querschnitt ausgeführt (Fig. 7). Die dergestalt durch die Leitung 23, z.B. eine Schlauchleitung, verringerte Saugleistung ermöglicht die Erzeugung einer gewünschten Druckdifferenz zwischen Prozessraum 3 und Kragenraum 11 bei geringem Stickstofffluss. Voraussetzung für die Ausbildung dieser Druckdifferenz ist eine passende Leckrate der Berührungsstelle von Quarzstopfen 6 und Prozessrohr 3, was durch einen Planschliff der sich berührenden Flächen (Dichtungsrand 3' und Rand 6') erreicht werden kann.

Der notwendige Prozessgasauslass 12 aus dem Prozessraum 1 in Form eines Ansaugstutzens befindet sich in der Mitte des Prozessrohres 3 auf der dem Rohrverschluss 2 gegenüber liegenden Seite und ist mit einem Kugelschliff 17 versehen und entweder nach unten geneigt, z.B. 5°, oder horizontal ausgerichtet (Fig. 1, 7). Der Vorteil des nach unten geneigten Prozessgasauslasses 12 ist darin zu sehen, dass flüssige oder nach dem Belüften der Vorrichtung verflüssigte Reaktionsprodukte und Anlagerungen, wie Phosphorsäure, abfließen können. Damit wird verhindert, dass der Prozessgasauslass 12 verstopft und es wird erreicht, dass sich möglichst wenige Stoffe anlagern, die das Prozessergebnis beeinflussen können.

An dem Kugelschliff 17 (Fig. 1, 7) kann eine spezielle Gasauslasslanze 18 (Fig. 6) aus Quarz, SiC oder einem anderen geeigneten Material, z.B. federbelastet, angeklemmt werden. Die Gasauslasslanze 18 ist mit einem Gasführungsrohr 19 in den Auslass 12 des Prozessrohrs 3 gesteckt (Fig. 1, 7)) und durch eine Kugelschliffverbindung 21 abgedichtet. Ein T-Stück 18' ist über einen Schlauch 23 mit dem Abpumpanschluss 20 der Tür 5 verbunden (Fig. 7). Ein äußeres Rohr 22 des T-Stückes 18' umgibt dabei das Gasführungsrohr 19 in einem vorgegebenen Abstand. Grundsätzlich kann anstelle des Kugelschliffs 17 auch ein Kegelschliff oder auch eine Verschraubung eingesetzt werden.

Die Gasauslasslanze 18 erfüllt mehrere Funktionen. Das wäre zunächst die Absaugung des Prozessraumes 1 durch das innen liegende Rohr 19, das in den Prozessraum 1 hineinreicht, so dass Substanzen aus dem Prozessraum 1, wie Phosphorsäure, nicht am Kugelschliff 17, 21 des Prozessgasauslasses 12 vorbei streichen und können sich somit dort nicht festsetzen.

Weiterhin erfolgt eine Spülung des Kugelschliffs 17, 21 mit Umgebungsluft durch konstruktionsbedingte Leckage des Kugelschliffs 17, 21, so dass bedingt durch die Druckdifferenz immer etwas Luft von außen eindringt.

Das vom Kragenraum 11 durch das T-Stück 18 in das äußere Rohr 22 strömende Gas isoliert dieses thermisch von dem hei-ße Abgase führenden inneren Rohr (Gasführungsrohr 19), so dass das äußere Rohr 22 mit einer thermoplastischen Dichtung an die weitere Abgasleitung angeschlossen werden kann.

Schließlich wird das innen liegende Gasführungsrohr 19 mit den abgesaugten Prozessgasen durch das im äußeren Rohr 22 strömende Gas thermisch isoliert. Das innere Rohr 22 kann auch zusätzlich zur Vermeidung von Kondensationserscheinungen geheizt werden.

Durch die Erfindung kann ein Prozessdruck von z.B. 50 mbar, also weit unter 200 mbar, gefahren werden. Als Prozessgase werden Sauerstoff, Stickstoff und POCl₃ mit Stickstoff als Trägergas eingesetzt.

Wesentlich für die Erfindung ist einerseits die räumliche Trennung der beiden Dichtungen für den Prozessraum 1 und die Tür 5 und dass sich die Dichtung und die Wand, d.h. der Boden des Quarzstopfens 6, die den Prozessraum 1 verschließen, möglichst nahe am beheizten Bereich des Prozessrohres 3 befinden und dadurch eine Temperatur nahe der Prozesstemperatur aufweisen. Auf diese Weise wird die Kondensation von Prozessgasen und deren Reaktionsprodukte und deren Reaktionen, die an Wänden mit ausreichen niedriger Temperatur ablaufen, insbesondere die Ablagerung von Phosphoroxid, im Prozessraum 1 vermieden.

Durch die räumliche Trennung kann die Dichtung, die für die Vakuumdichtheit sorgt, die für das Erreichen des gewünschten Prozessdrucks erforderlich ist, ausreichend weit entfernt und durch Isolierung und Wärmestrahlenschutz abgeschirmt von den beheizten Bereich des Prozessrohres 3 angebracht werden. Die Dichtung 15 und die Tür 5 können ohne negative Auswirkungen auf den Prozess und den Prozessraum aktiv gekühlt werden. Dadurch ist die Temperatur an der Vakuumdichtung 15 und der Tür 5 deutlich niedriger, als die Prozesstemperatur, was die Verwendung geeigneter Werkstoffe für die Dichtung 15 zwischen Prozessrohr (z.B. aus Quarz) und Tür (z.B. aus Aluminium) hier z.B. Silikon und PTFE und für die Tür 5 selbst (z.B. Aluminium) ermöglicht. Eine ausreichend kalte Tür 5 ist auch eine Voraussetzung für das Anbringen von Schläuchen, z.B. Schlauch 23, und die zuverlässige Funktion der Mechanik zur Türbetätigung, sowie einen insgesamt geeigneten Wärmehaushalt der Anlage.

Kern der erfindungsgemäßen Vorrichtung zur Dotierung, Beschichtung und Oxydation von Halbleitermaterial oder sonstigen Substraten bei niedrigem Druck ist der vakuumtaugliche Verschluss des Prozessrohres 3 mit zwei "gasdichten" Dichtungen. Die erste Dichtung ist eine federbelastete geschliffene Quarz-Quarz-Dichtung zwischen dem Dichtungsrand 3' des Prozessrohres 3 und dem geschliffenen Rand 6' des Quarzstopfens 6. Diese Dichtung ist temperaturfest und kann somit den Prozessraum 1 an sehr heißer Stelle abdichten. Eine Kondensation von Prozessgasen kann dadurch sicher verhindert werden.

Eine solche Dichtung ist nur bedingt dicht, d.h. bei großen Differenzdrücken ergibt sich eine relativ hohe Leckrate und sie lässt sich nur mit Mühe druckfest gestalten. Der maximale Differenzdruck liegt bei etwa 1 bar. Darüber hinaus müsste eine sehr dicke Quarzplatte bei dennoch bestehendem Bruchrisiko eingesetzt werden.

Beide Probleme werden durch die erfindungsgemäße zweite Dichtung zwischen dem Rand der Tür 5 und dem Stirnrand des Kragens 4, also einer plastisch gedichteten Metall-Quarz-Dichtung, gelöst. Da eine solche Dichtung nicht korrosionsbeständig ist, erfolgt die Spülung des Kragenraumes 11 durch die Tür 5 mit einem Spülgas, z.B. Stickstoff, wie bereits beschrieben.

### Bezugszeichenliste

- 1: Prozessraum
- 2: Rohrverschlussende
- 3: Prozessrohr
- 3': Dichtungsrand
- 4: Kragen
- 5: Tür
- 6: Quarzstopfen
- 6': geschliffener Rand
- 7: Federelement
- 8: Bajonettverschluss
- 9: Kühlwassereinlass
- 10: Kühlwasserauslass
- 11: Kragenraum
- 12: Prozessgasauslass
- 13: Stutzen
- 14: Koaxialrohr
- 15: Dichtung
- 16: Spülgaseinlass
- 17: Kugelschliff
- 18: Gasauslasslanze
- 18': T-Stück
- 19: Gasführungsrohr
- 20: Spülgasauslass/Abpumpanschluss
- 21: Kugelschliffverbindung
- 22: äußeres Rohr
- 23: Schlauchleitung

- W: Wafer
- H: Heizung
- K: Kühlfalle
- P: Pumpe

## Patentansprüche

1. Vorrichtung zur Dotierung, Beschichtung oder Oxidation von Halbleitermaterial bei niedrigem Druck in einem Prozessrohr, das mit einem Rohrverschluss sowie Einrichtungen zur Zu- und Ableitung von Prozessgasen und zur Erzeugung eines Unterdruckes im Prozessrohr versehen ist, bei welcher ein in Bezug auf die Prozessgase gasdichter Abschluss des Prozessraumes (1) und die vakuumdichte Abdichtung des Rohrverschlussendes (2) gegenüber der Atmosphäre räumlich voneinander getrennt auf der selben Seite des Prozessrohres (3) angeordnet sind, derart, dass die vakuumdichte Abdichtung des Rohrverschlussendes (2) durch einen am Prozessrohr (3) befestigten Kragen (4) erfolgt, an dem eine Tür (5) dichtend anliegt,
**dadurch gekennzeichnet,**
- **dass** der gasdichte Abschluss des Prozessraumes (1) derart angeordnet ist, dass der Boden eines Stopfens (6) den Prozessraum (1) abdichtend an einem Dichtungsrand (3') des Prozessrohres (3) anliegt, und
- **dass** ein Rand des Bodens des Stopfens (6) im geschossenen Zustand der Tür (5) an dem Dichtungsrand (3') des Prozessrohres (3) federbelastet anliegt.

2. Vorrichtung nach Anspruch 1,
**dadurch gekennzeichnet,**
**dass** der Kragen (4) das Prozessrohr (3) stirnseitig überragt, so dass innerhalb des Kragens (4) ein Kragenraum (11) entsteht, der durch die Tür (5) vakuumdicht verschließbar ist.

3. Vorrichtung nach Anspruch 2, **dadurch gekennzeichnet, dass** die vakuumdichte Abdichtung des Rohrverschlussendes (2) mit der Tür (5) erfolgt, die unter Zwischenlage einer Dichtung (15) stirnseitig an den Rand des Kragens (4) anlegbar ist.

4. Vorrichtung nach einem der Ansprüche 1 bis 3, **dadurch gekennzeichnet, dass** der Stopfen (6) an der Innenseite der Tür (5) lösbar und federbelastet befestigt ist.

5. Vorrichtung nach Anspruch 4, **dadurch gekennzeichnet, dass** die Befestigung des Stopfens (6) an der Tür (5) mittels eines Bajonettverschlusses (8) erfolgt.

6. Vorrichtung nach einem der Ansprüche 1 bis 5, **dadurch gekennzeichnet, dass** der Stopfen (5) aus Quarz, SiC oder einem anderen hinreichend temperaturbeständigen und medienresistenten Material besteht.

7. Vorrichtung nach einem der Ansprüche 1 bis 5, **dadurch gekennzeichnet, dass** der Stopfen (5) mit Quarz, SiC oder einem anderen hinreichend temperaturbeständigen und medienresistenten Material beschichtet ist.

8. Vorrichtung nach einem der Ansprüche 1 bis 5, **dadurch gekennzeichnet, dass** die Tür (5) aus Aluminium besteht.

9. Vorrichtung nach Anspruch 8, **dadurch gekennzeichnet, dass** die Tür (5) wassergekühlt ist.

10. Vorrichtung nach Anspruch 8 und 9, **dadurch gekennzeichnet, dass** die Tür (5) mit einem Kühlwassereinlass (9) und einem Kühlwasserauslass (10) zur Hindurchleitung eines Kühlmittels versehen ist.

11. Vorrichtung nach Anspruch 10, **dadurch gekennzeichnet, dass** zur Verteilung des Kühlmittels eine ringförmige Nut in der Tür (5) vorgesehen ist.

12. Vorrichtung nach einem der Ansprüche 1 bis 11, **dadurch gekennzeichnet, dass** die Tür (5) mit einem Spülgaseinlass (16) zur Einleitung eines Spülgases in den Kragenraum (11) versehen ist und einen Spülgasauslass (20) aufweist.

13. Vorrichtung nach Anspruch 12, **dadurch gekennzeichnet, dass** der Spülgasauslass (20) über eine Schlauchleitung (23) mit einem Gasführungsrohr (19) und einer Pumpe (P) zum Abpumpen des Spülgases aus der Kammer (11) und der Prozessgase aus dem Prozessraum (1) verbunden ist.

14. Vorrichtung nach Anspruch 13, **dadurch gekennzeichnet, dass** der Gaseinlass (16) mit einer Quelle für Stickstoff verbunden ist.

15. Vorrichtung nach einem der Ansprüche 1 bis 14, **dadurch gekennzeichnet, dass** im Kragenraum (11) ein Überdruck gegenüber dem Prozessraum (1) im Prozessrohr (3) besteht.

16. Vorrichtung nach Anspruch 15, **dadurch gekennzeichnet, dass** die Druckdifferenz zwischen Null und ca. 50 mbar beträgt.

17. Vorrichtung nach einem der Ansprüche 1 bis 16, **dadurch gekennzeichnet, dass** für die Evakuierung des Prozessraumes (1) und des Kragenraumes (11) und zur Erzeugung der Druckdifferenz zwischen Prozessraum (1) und Kragenraum (11) eine gemeinsame Pumpe (P) vorgesehen ist.

18. Vorrichtung nach Anspruch 17, **dadurch gekennzeichnet, dass** zur Erzeugung der Druckdifferenz die Verbindung des Kragenraumes (11) zur Pumpe (P) mit einer im Vergleich zur Prozessrohrabsaugung langen Leitung (23) mit geringerem Querschnitt ausgeführt ist.

19. Vorrichtung nach Anspruch 17 und 18, **dadurch gekennzeichnet, dass** vor der Pumpe (P) eine Kühlfalle (K) angeordnet ist.

20. Vorrichtung nach den Ansprüchen 17 bis 19, **dadurch gekennzeichnet, dass** die Pumpe (P) als Membranpumpe, Schraubenpumpe oder Strahlpumpe ausgebildet ist.

21. Vorrichtung nach einem der Ansprüche 18 bis 19, **dadurch gekennzeichnet, dass** zur Ausbildung dieser Druckdifferenz eine passende Leckrate der Berührungsstelle von Quarzstopfen (6) und dem Dichtungsrand (3') des Prozessrohres (3) durch einen Planschliff der sich berührenden Flächen eingestellt ist.

22. Vorrichtung nach einem der Ansprüche 1 bis 21, **dadurch gekennzeichnet, dass** sich der Prozessgasauslass (12) zur Ableitung der Prozessgase an der dem Rohrverschluss (2) gegenüber liegenden Ende des Prozessrohres (3) befindet.

23. Vorrichtung nach Anspruch 22, **dadurch gekennzeichnet, dass** der Prozessgasauslass (12) mit einem Kugelschliff (20) versehen ist.

24. Vorrichtung nach Anspruch 22 und 23, **dadurch gekennzeichnet, dass** der Prozessgasauslass (12) entweder nach unten geneigt, oder horizontal ausgerichtet ist.

25. Vorrichtung nach Anspruch 24, **dadurch gekennzeichnet, dass** der Prozessgasauslass um ca. 5° nach unten geneigt ist.

26. Vorrichtung nach einem der Ansprüche 22 bis 25, **dadurch gekennzeichnet, dass** der Kugelschliff (17) am Gasauslass (12) zum Anschluss und zur Hindurchführung einer Gasauslasslanze (18) ausgebildet ist.

27. Vorrichtung nach einem der Ansprüche 1 bis 26, **dadurch gekennzeichnet, dass** die Absaugung des Kragenraumes (11) durch das Gasführungsrohr (19) über ein T-Stück (18') erfolgt, durch welches das Gasführungsrohr (19) geführt ist.

28. Vorrichtung nach einem der Ansprüche 1 bis 27, **dadurch gekennzeichnet, dass** der Prozessgaseinlass in den Prozessraum (1) durch ein Koaxialrohr (14) als Bestandteil einer Gaseinlasslanze auf der Seite des Prozessgasauslasses (12) erfolgt, die bis an den Quarzstopfen (6) auf der anderen Seite des Prozessrohres (3) reicht, ohne diesen zu berühren.

## Claims

1. Device for doping, coating or oxidation of semiconductor material at low pressure in a process tube, which is provided with a tube closure as well as with devices for supplying and discharging process gases and for generating a negative pressure in the process tube, wherein a, with respect to the process gases, gas-tight closure of the process volume (1) and the vacuum-tight sealing of the tube closure end (2) against the atmosphere are arranged spatially separated from each other on the same side of the process tube (3) in such a manner that the vacuum-tight sealing of the tube closure end (2) is realised by means of a collar (4), which is attached to the process tube (3) and against which a door (5) rests sealingly,
**characterised**
- **in that** the gas-tight closure of the process volume (1) is arranged in such a manner that the bottom of a stopper (6) rests against a sealing rim (3') of the process tube (3) sealing the process volume (1), and
- **in that** in closed state of the door (5), a rim of the bottom of the stopper (6) rests against the sealing rim (3') of the process tube (3) in a spring-loaded manner.

2. Device according to claim 1,
**characterised**
**in that** the collar (4) projects beyond the process tube (3) on a face side so that a collar volume (11), which is vacuum-tightly closable by the door (5), is formed inside the collar (4).

3. Device according to claim 2,
**characterised**
**in that** the vacuum-tight sealing of the tube closure end (2) is realised by means of the door (5), which is frontally placeable against the outer rim of the collar (4) with interposition of a seal (15).

4. Device according to one of the claims 1 to 3,
**characterised**
**in that** the stopper (6) is attached to the inside of the door (5) in a detachable and spring-loaded manner.

5. Device according to claim 4,
**characterised**
**in that** attaching of the stopper (6) to the door (5) is realised by means of a bayonet closure (8).

6. Device according to one of the claims 1 to 5,
**characterised**
**in that** the stopper (5) consists of quartz, Sic or another adequately temperature stable and medium resistant material.

7. Device according to one of the claims 1 to 5,
**characterised**
**in that** the stopper (5) is coated with quartz, SiC or another adequately temperature stable and medium resistant material.

8. Device according to one of the claims 1 to 5,
**characterised**
**in that** the door (5) consists of aluminium.

9. Device according to claim 8,
**characterised**
**in that** the door (5) is water cooled.

10. Device according to claim 8 and 9,
**characterised**
**in that** the door (5) is provided with a cooling water inlet (9) and a cooling water outlet (10) for through passing of a coolant.

11. Device according to claim 10,
**characterised**
**in that** a ring-shaped groove is provided in the door (5) for distributing the coolant.

12. Device according to one of the claims 1 to 11,
**characterised**
**in that** the door (5) is provided with a flushing gas inlet (16) for introducing a flushing gas into the collar volume (11) and comprises a flushing gas outlet (20).

13. Device according to claim 12,
**characterised**
**in that** the flushing gas outlet (20) is connected by a hose line (23) to a gas conveying tube (19) and a pump (P) for pumping the flushing gas out of the chamber (11) and for pumping the process gases out of the process volume (1).

14. Device according to claim 13,
**characterised**
**in that** the gas inlet (16) is connected to a source of nitrogen.

15. Device according to one of the claims 1 to 14,
**characterised**
**in that** the collar volume (11) exhibits an overpressure in relation to the process volume (1) in the process tube (3).

16. Device according to claim 15,
**characterised**
**in that** the pressure differential is between zero and approximately 50 mbar.

17. Device according to one of the claims 1 to 16,
**characterised**
**in that** a common pump (P) is provided for evacuating the process volume (1) and the collar volume (11) and for generating the pressure differential between process volume (1) and collar volume (11).

18. Device according to claim 17,
**characterised**
**in that** for the purpose of generating the pressure differential the connection of the collar volume (11) to the pump (P) is realised with a line (23) having, as compared to the process tube extraction, a larger length and a smaller cross section.

19. Device according to claim 17 and 18,
**characterised**
**in that** a cooling trap (K) is arranged upstream of the pump (P).

20. Device according to claims 17 to 19,
**characterised**
**in that** the pump (P) is designed as a diaphragm pump, screw pump or jet pump.

21. Device according to one of the claims 18 to 19,
**characterised**
**in that** for the purpose of developing said pressure differential a suitable leak rate of the contact point of the quartz stopper (6) and the sealing rim (3') of the process tube (3) is set by means of a flat finish of surfaces that meet.

22. Device according to one of the claims 1 to 21,
**characterised**
**in that** the process gas outlet (12) for discharging the process gases is located on the end of the process tube (3) that lies opposite to the tube closure (2).

23. Device according to claim 22,
**characterised**
**in that** the process gas outlet (12) is provided with a spherical ground joint (20).

24. Device according to claim 22 and 23,
**characterised**
**in that** the process gas outlet (12) is either downwardly sloped or horizontally aligned.

25. Device according to claim 24,
**characterised**
**in that** the process gas outlet is sloped downwardly by approximately 5°.

26. Device according to one of the claims 22 to 25,
**characterised**
**in that** the spherical ground joint (17) at the gas outlet (12) is configured for attaching and for through passing of a gas outlet lance (18).

27. Device according to one of the claims 1 to 26,
**characterised**
**in that** evacuating of the collar volume (11) via the gas conveying tube (19) is realised by means of a T-piece (18'), through which the gas conveying tube (19) is run.

28. Device according to one of the claims 1 to 27,
**characterised.**
**in that** supplying of process gas into the process volume (1) is realised by means of a coaxial tube (14) as a component of a gas inlet lance on the side of the process gas outlet (12), said gas inlet lance extending to the quartz stopper (6) on the other side of the process tube (3) without touching said stopper.

## Revendications

1. Dispositif de dopage, de revêtement ou d'oxydation de matériau semiconducteur à basse pression dans un tuyau de traitement qui est pourvu d'un bouchon de tuyau ainsi que de dispositifs pour l'amenée et l'évacuation de gaz de traitement et pour produire une dépression dans le tuyau de traitement, dispositif pour lequel une fermeture étanche au gaz pour ce qui est des gaz de traitement de l'espace de traitement (1) et la fermeture étanche au vide de l'extrémité du bouchon de tuyau (2) sont placées séparément l'un de l'autre dans l'espace par rapport à l'atmosphère du même côté du tuyau de traitement (3) de telle manière que la fermeture étanche au vide de l'extrémité du bouchon de tuyau (2) se fait par une collerette (4) fixée au tuyau de traitement (3) contre laquelle une porte (5) adhère de manière étanche,
**caractérisé en ce**
- **que** la fermeture étanche au gaz de l'espace de traitement (1) est placée de telle manière que le fond d'un bouchon (6) est appliqué sur un bord d'étanchéité (3') du tuyau de traitement (3) en rendant étanche l'espace de traitement (1) et
- **qu'**un bord du fond du bouchon (6) est appliqué, lorsque la porte (5) est à l'état fermé, sur le bord d'étanchéité (3') du tuyau de traitement (3) en étant chargé par un ressort.

2. Dispositif selon la revendication 1,
**caractérisé en ce**
**que** la collerette (4) dépasse du tuyau de traitement (3) sur le côté frontal si bien qu'un espace de collerette (11), qui peut être fermé en étant étanche au vide par la porte (5), se forme à l'intérieur de la collerette (4).

3. Dispositif selon la revendication 2, **caractérisé en ce que** la fermeture étanche au vide de l'extrémité du bouchon de tuyau (2) se fait avec la porte (5) qui peut être appliquée sur le bord de la collerette (4) sur le côté frontal en intercalant une étanchéité (15).

4. Dispositif selon l'une des revendications 1 à 3, **caractérisé en ce que** le bouchon (6) est fixé amovible et chargé par un ressort sur le côté intérieur de la porte (5).

5. Dispositif selon la revendication 4, **caractérisé en ce que** la fixation du bouchon (6) sur la porte (5) se fait au moyen d'une fermeture à baïonnette (8).

6. Dispositif selon l'une des revendications 1 à 5, **caractérisé en ce que** le bouchon (6) est en quartz, en SiC ou en un autre matériau suffisamment résistant aux températures élevées et résistant aux fluides.

7. Dispositif selon l'une des revendications 1 à 5, **caractérisé en ce que** le bouchon (6) est revêtu en quartz, en SiC ou en un autre matériau suffisamment résistant aux températures élevées et résistant aux fluides.

8. Dispositif selon l'une des revendications 1 à 5, **caractérisé en ce que** la porte (5) est en aluminium.

9. Dispositif selon la revendication 8, **caractérisé en ce que** la porte (5) est refroidie par de l'eau.

10. Dispositif selon la revendication 8 et 9, **caractérisé en ce que** la porte (5) est pourvue d'une entrée pour l'eau de refroidissement (9) et une sortie pour l'eau de refroidissement (10) pour faire traverser une substance de refroidissement.

11. Dispositif selon la revendication 10, **caractérisé en ce qu'**une rainure annulaire est prévue dans la porte (5) pour la répartition de la substance de refroidissement.

12. Dispositif selon l'une des revendications 1 à 11, **caractérisé en ce que** la porte (5) est pourvue avec une entrée de gaz de purge (16) pour introduire un gaz de purge dans l'espace de collerette (11) et présente une sortie de gaz de purge (20).

13. Dispositif selon la revendication 12, **caractérisé en ce que** la sortie de gaz de purge (20) est reliée par une tuyauterie (23) à un tuyau de conduite de gaz (19) et à une pompe (P) pour pomper le gaz de purge de la chambre (11) et des gaz de traitement de l'espace de traitement (1).

14. Dispositif selon la revendication 13, **caractérisé en ce que** l'entrée de gaz de purge (16) est reliée à une source d'azote.

15. Dispositif selon l'une des revendications 1 à 14, **caractérisé en ce qu'**il y a une surpression dans l'espace de collerette (11) par rapport à l'espace de traitement (1) dans le tuyau de traitement (3).

16. Dispositif selon la revendication 15, **caractérisé en ce que** la différence de pression est entre zéro et env. 50 mbar.

17. Dispositif selon l'une des revendications 1 à 16, **caractérisé en ce qu'**il est prévu une pompe commune (P) pour l'évacuation de l'espace de traitement (1) et de l'espace de collerette (11) et pour produire la différence de pression entre l'espace de traitement (1) et l'espace de collerette (11).

18. Dispositif selon la revendication 17, **caractérisé en ce que**, pour produire la différence de pression la jonction de l'espace de collerette (11) et de la pompe (P) est réalisée avec une longue tuyauterie (23) de section plus faible par comparaison avec l'aspiration du tuyau de traitement.

19. Dispositif selon la revendication 17 et 18, **caractérisé en ce qu'**un piège cryogénique (K) est placé devant la pompe (P).

20. Dispositif selon les revendications 17 à 19, **caractérisé en ce que** la pompe est configurée comme une pompe à diaphragme, une pompe hélicoïdale ou une pompe à jet.

21. Dispositif selon l'une des revendications 18 à 19, **caractérisé en ce que**, pour former cette différence de pression, un taux de fuite convenant du point de contact du bouchon en quartz (6) et du bord d'étanchéité (3') du tuyau de traitement (3) est ajusté par un rodage plan des surfaces en contact.

22. Dispositif selon l'une des revendications 1 à 21, **caractérisé en ce que** la sortie de gaz de traitement (12) pour l'évacuation des gaz de traitement à l'extrémité du tuyau de traitement (3) se trouve à l'extrémité située en face du en face du bouchon de tuyau (2).

23. Dispositif selon la revendication 22, **caractérisé en ce que** la sortie de gaz de traitement (12) est pourvue d'un meulage sphérique (20).

24. Dispositif selon les revendications 22 et 23, **caractérisé en ce que** la sortie de gaz de traitement est orientée soit inclinée vers le bas, soit horizontalement.

25. Dispositif selon la revendication 24, **caractérisé en ce que** la sortie de gaz de traitement est inclinée d'environ 5° vers le bas.

26. Dispositif selon l'une des revendications 22 à 25, **caractérisé en ce que** le meulage sphérique (17) est configuré à la sortie de gaz (12) pour le raccord et le passage d'une lance de sortie de gaz (18),

27. Dispositif selon l'une des revendications 1 à 26, **caractérisé en ce que** l'aspiration de l'espace de collerette (11) par un tuyau de conduite de gaz (19) se fait une pièce en T (18') à travers laquelle le tuyau de conduite de gaz (19) est guidé.

28. Dispositif selon l'une des revendications 1 à 27, **caractérisé en ce que** l'entrée de gaz de traitement dans l'espace de traitement (1) se fait par un tuyau axial (14) comme partie constituante d'une lance d'entrée de gaz sur le côté de la sortie de gaz de traitement (12) qui va jusqu'au bouchon de quartz (6) de l'autre côté du tuyau de traitement (3) sans le toucher.
